# EUROPEAN PATENT APPLICATION

(11) **EP 4 811 990 A1**
(43) Date of publication of application: **23.09.2026**
(21) Application number: 24891675.1
(22) Date of filing: 25.10.2024
(51) Int. Cl.: H10K 59/80, H10K 59/40, H10K 59/12, H10K 71/00

(54) **DISPLAY DEVICE AND MANUFACTURING METHOD THEREFOR**

(30) Priority: 14.11.2023 KR 20230157322
(71) Applicant: Samsung Display Co., Ltd., Yongin-si, Gyeonggi-do 17113 (KR)
(72) Inventor: LEE, Joon Ik, Yongin-Si Gyeonggi-do 17113 (KR); KIM, Dong Hwan, Yongin-Si Gyeonggi-do 17113 (KR); YOU, Jun Woo, Yongin-Si Gyeonggi-do 17113 (KR); LEE, Chang Moo, Yongin-Si Gyeonggi-do 17113 (KR)
(74) Representative: Marks & Clerk LLP
(86) International application number: PCT/KR2024/016435
(87) International publication number: WO 2025/105728

(57) **Abstract**

The present invention relates to a display device, and more particularly, to a display device and a method for fabricating the same, which can improve image quality by minimizing light leakage. The present invention includes a display device according to an embodiment of the present invention comprises: a base substrate a display element disposed on the base substrate in a display area; an encapsulation layer on the display element; and a light shielding layer disposed on the encapsulation layer in a non-display area.

## Description

### [Technical Field]

The present invention relates to a display device, and more particularly, to a display device and a method for fabricating the same, which can improve image quality by minimizing light leakage.

### [Background Art]

Various types of electronic devices, including display modules, are used to provide image information, and electronic devices may include electronic modules that receive external signals or provide output signals to the outside. For example, electronic modules may include camera modules, etc., and the demands for display devices that can obtain high-quality captured images are increasing.

### [Disclosure of the Invention]

### [Technical Problem]

The present invention aims to provide a display device and a method for fabricating the same, which can improve image quality by minimizing light leakage.
The problems to be solved by the present invention are not limited to those mentioned above, and other technical problems not mentioned will be clearly understood by those skilled in the art from the following description.

### [Technical Solution]

In order to achieve the above object, a display device according to an embodiment of the present invention comprises: a base substrate 100; a display element 200 disposed on the base substrate in a display area DA; an encapsulation layer 300 on the display element; and a light shielding layer 800 disposed on the encapsulation layer in a non-display area NDA.

In an embodiment, the light shielding layer is disposed along the edge of the upper surface of the base substrate and the edge of the upper surface of the encapsulation layer.

In an embodiment, in plan view, the light shielding layer surrounds at least one of the encapsulation layer, the display element, and the display area of the base substrate.

In an embodiment, in plan view, the light shielding layer has a closed curve shape surrounding at least one of the encapsulation layer, the display element, and the display area of the base substrate.

In an embodiment, in a non-display area of the base substrate, the light shielding layer is disposed directly on the encapsulation layer.

In an embodiment, in the non-display area of the base substrate, the light shielding layer is in contact with the encapsulation layer.

In an embodiment, an interface between the light shielding layer and the encapsulation layer has a round shape.

In an embodiment, the display device further comprises an adhesive layer on the encapsulation layer and the light shielding layer.

In an embodiment, the display device further comprises a touch sensing unit 900 disposed between the encapsulation layer and the adhesive layer, and also disposed between the encapsulation layer and the light shielding layer.

In an embodiment, the light shielding layer is in contact with the touch sensing unit.

In an embodiment, the display device further comprises a first planarization layer 910 between the encapsulation layer and the touch sensing unit.

In an embodiment, the display device further comprises a second planarization layer 920 disposed between the touch sensing unit and the adhesive layer, and also disposed between the touch sensing unit and the light shielding layer.

In an embodiment, the display device further comprises a protective substrate 500 on the adhesive layer.

In an embodiment, the display device further comprises a polarization plate 600 on the protective substrate.

In an embodiment, the light shielding layer is disposed on the protective substrate to overlap the edge of the encapsulation layer.

In an embodiment, the light shielding layer is disposed directly on the protective substrate.

In an embodiment, in plan view, the light shielding layer surrounds the polarization plate.

In an embodiment, the light shielding layer comprises: a first light shielding layer 800 disposed directly on the encapsulation layer; and a second light shielding layer 820 disposed directly on the protective substrate to overlap the encapsulation layer.

In an embodiment, the display device further comprises a dam 350 disposed on the base substrate to overlap the light shielding layer in the non-display area of the base substrate.

In an embodiment, a portion of the encapsulation layer is disposed between the dam and the light shielding layer.

In an embodiment, the light shielding layer includes a black pigment or an organic black pigment.

In an embodiment, the light shielding layer has a square ring shape with four sides.

In an embodiment, the four sides comprise: a first side adjacent to a pad area PDA of the base substrate; a second side disposed to face the first side; a third side connected to one end of the first side and one end of the second side; and a fourth side disposed to face the third side, and connected to the other end of the first side and the other side of the second side.

In an embodiment, the width of the first side and the width of the second side are the same, and the third side and the width of the third side are different.

According to an embodiment of the disclosure, a method for fabricating a display device comprises: placing a display element on a display area of a base substrate; placing an encapsulation layer on the display element; and placing a light shielding layer on the encapsulation layer in a non-display area of the base substrate.

The specific details of other embodiments are included in the detailed description and drawings.

### [Advantageous Effects of the Invention]

According to the display device of the present invention, light leakage in the display device can be minimized. Therefore, the image quality of the display device can be improved. In addition, according to the display device of the present invention, moisture penetration into the display device can be prevented.

Meanwhile, the effects obtainable from the present invention are not limited to those mentioned above, and other effects not mentioned will be clearly understood by those skilled in the art from the following description.

### [Brief Description of the Drawings]

FIG. 1 is a schematic plan view of a display device according to an embodiment;
FIG. 2 is a schematic cross-sectional view taken along line I-I' of FIG. 1;
FIGS. 3 to 6 are schematic drawings for describing a method of manufacturing a display device according to an embodiment;
FIG. 7 is schematic cross-sectional view of a display device according to an embodiment;
FIG. 8 is a schematic cross-sectional view of a display device according to an embodiment;
FIG. 9 is a schematic cross-sectional view of a display device according to an embodiment;
FIG. 10 is a schematic cross-sectional view of a display device according to an embodiment;
FIG. 11 is a schematic cross-sectional view of a display device according to an embodiment; and
FIG. 12 is a schematic cross-sectional view of a display device according to an embodiment.

### [Mode for Carrying Out the Invention]

The advantages and features of the present invention, and methods for achieving them, will be clearly understood by referring to the embodiments described in detail below together with the accompanying drawings. However, the present invention is not limited to the embodiments disclosed below but may be implemented in various different forms. The embodiments are provided merely to complete the disclosure of the present invention and to fully inform those skilled in the art of the scope of the invention, which is defined only by the scope of the claims.

The expression that an element or layer is "on" another element or layer includes both the case where it is directly on the other element and the case where another layer or element is interposed in between. Throughout the specification, like reference numerals denote like elements. The shapes, sizes, ratios, angles, numbers, and the like disclosed in the drawings for describing the embodiments are merely illustrative, and the present invention is not limited to those illustrated features.

Although terms such as first, second, etc., are used to describe various components, it is to be understood that these components are not limited by these terms. These terms are only used to distinguish one component from another. Therefore, a first component mentioned below may also be referred to as a second component within the technical scope of the present invention.

The respective features of the various embodiments of the present invention may be combined or selectively combined in whole or in part, various technical linkages and operations are possible, and each embodiment may be independently implemented or implemented in association with each other.

Specific embodiments will be described below with reference to the accompanying drawings.

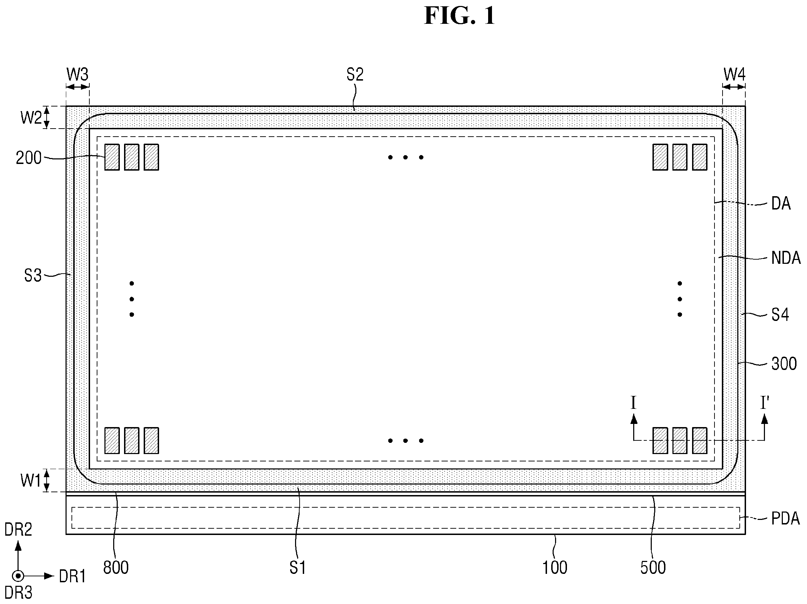

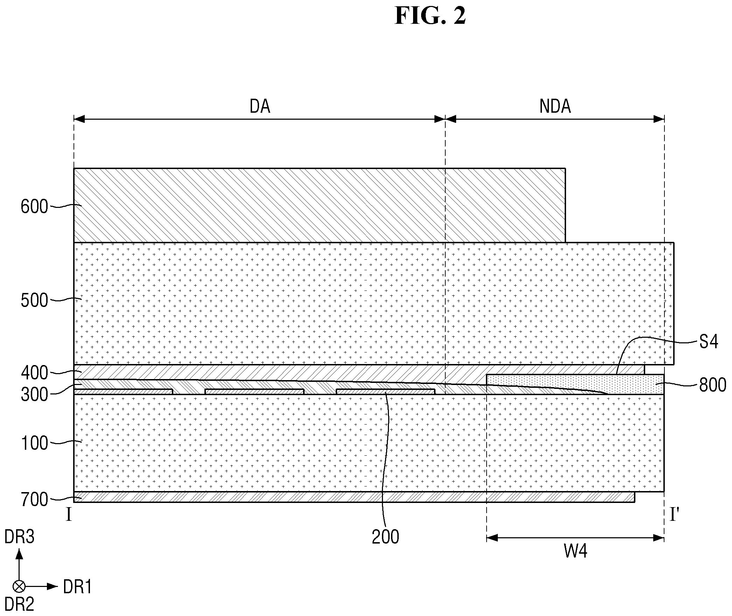

FIG. 1 is a schematic plan view of a display device according to an embodiment, and FIG. 2 is a schematic cross-sectional view taken along line I-I' of FIG. 1.

As illustrated in FIGS. 1 and 2, a display device according to an embodiment may include a protective layer 700, a base substrate 100, a plurality of display elements 200, an encapsulation layer 300, an adhesive layer 400, a protective substrate 500, a polarization plate 600, and a light shielding layer 800.

The protective layer 700 may protect the bottom surface of the base substrate 100 as well as performing a light-shielding function. For example, the protective layer 700 may prevent a scratch from occurring on the bottom surface of the base substrate 100. For this, the protective layer 700 may be disposed on the bottom surface of the base substrate 100.

The base substrate 100 may be disposed on the protective layer 700. The base substrate 100 may be a flexible substrate which can be bent, folded or rolled. For example, the base substrate 100 may include a polymer resin such as polyimide (PI), but is not limited thereto. For another example, the base substrate 100 may include a glass material or a metal material. Here, the glass may be a flexible or rigid glass, and the metal may be a flexible or rigid metal. According to a display device according to an embodiment, the base substrate 100 may be, for example, an ultra-thin glass. The ultra-thin glass may have**,** for example, a very thin thickness through an etching process. Here, the thickness of the base substrate 100 may mean a magnitude in a third direction DR3.
The plurality of display elements 200 may be disposed on the base substrate 100. For example, the display elements 200 may be disposed on the base substrate 100 in the third direction DR3. At this time, the display elements 200 may be disposed on a display area DA of the base substrate 100. The display device 200 may include a light emitting element. The light emitting element may include an anode electrode, a light emitting layer, and a cathode electrode. The anode electrode, the light emitting layer, and the cathode electrode may be sequentially stacked along the third direction DR3. For example, a light emitting layer may be stacked on the anode electrode in the third direction DR3, and a cathode electrode may be disposed on the light emitting layer in the third direction DR3.

The light emitting layer may be an organic light emitting layer including an organic material. The light emitting layer may include a hole transporting layer, an organic light emitting layer, and an electron transporting layer. When the anode electrode receives a predetermined voltage through a thin film transistor and the cathode electrode receives the cathode voltage, holes and electrons may be transferred to the organic light emitting layer through the hole transporting layer and the electron transporting layer, respectively, and may be combined with each other to emit light in the organic light emitting layer.

In another example, the light emitting elements may include a quantum dot light emitting diode including a quantum dot light emitting layer, an inorganic light emitting diode including an inorganic semiconductor, or a micro light emitting diode.

The encapsulation layer 300 may be disposed on the light emitting elements 200. For example, the encapsulation layer 300 may be disposed on the light emitting elements 200 in the third direction DR3. The encapsulation layer 300 may cover the top and side surfaces of each of the light emitting elements 200 and protect the light emitting elements 200. The encapsulation layer 300 may include at least one inorganic layer and at least one organic layer for encapsulating the light emitting elements 200. For example, the encapsulation layer 300 may include a first inorganic layer, an organic layer, and a second inorganic layer sequentially stacked along a third direction on the base substrate 100.

The light shielding layer 800 may be disposed on the encapsulation layer 300 and the base substrate 100. As illustrated in FIGS. 1 and 2, the light shielding layer 800 may be disposed in a non-display area NDA of the base substrate 100. From a plan view as illustrated in FIG. 1, the light shielding layer 800 may have a shape of a closed curve surrounding the display area DA of the base substrate 100. For example, as illustrated in FIGS. 1 and 2, the light shielding layer 800 may have a shape of a closed curve surrounding at least one of the display area DA, the plurality of display elements 200, and the encapsulation layer 300 in the non-display area NDA.

As illustrated in FIG. 2, the light shielding layer 800 may be disposed on an edge of the upper surface of the base substrate 100. For example, the light shielding layer 800 may be disposed on the base substrate 100 in the third direction DR3, and at this time, the light shielding layer 800 may be disposed along the edge of the upper surface of the base substrate 100. The upper surface of the base substrate 100 may be the surface on which the above-described display elements 200 are disposed.

The light shielding layer 800 may be disposed along the edge of the upper surface of the base substrate 100 and the edge of the upper surface of the encapsulation layer 300. The light shielding layer 800 may face the edge of the upper surface of the base substrate 100 and the edge of the upper surface of the encapsulation layer 300 in the third direction DR3. At this time, at the edge of the upper surface of the base substrate 100, the light shielding layer 800 may be in contact with (or be in direct contact with) the upper surface of the base substrate 100. In addition, at the edge of the upper surface of the encapsulation layer 300, the light shielding layer 800 may be in contact with (or be in direct contact with) the encapsulation layer 300. The edge of the encapsulation layer 300 may be disposed between the base substrate 100 and the light shielding layer 800.

As illustrated in FIG. 2, the light shielding layer 800 may be disposed directly on the base substrate 100 and directly on the encapsulation layer 300 in the non-display area NDA.

As illustrated in FIG. 2, an interface between the light shielding layer 800 and the encapsulation layer 300 may have a round shape.

The light shielding layer 800 may include a light absorbing material (or an opaque material). For example, the light shielding layer 800 may include an inorganic black pigment or an organic black pigment. The inorganic black pigment may be a carbon black and the organic black pigment may include at least one of Lactam Black, Perylene Black, and Aniline Black, but the present disclosure is not limited thereto. For example, the light shielding layer 800 may be made of a material containing any one of colors other than black. According to an embodiment, the light shielding layer 800 may include an opaque white material.

As illustrated in FIG. 1, the light shielding layer 800 may have a square ring shape with four sides. For example, the four sides may include a first side S1, a second side S2, a third side S3, and a fourth side S4. The first side S1 may be disposed adjacent to a pad area PDA of the base substrate. The second side S2 may be arranged to face the first side S1 in a second direction DR2. The third side S3 may be connected to one end of the first side S1 and one end of the second side S2. The fourth side S4 may be disposed to face the third side S3 in a first direction DR1, and may be connected to the other end of the first side S1 and the other end of the second side S2. The first to fourth sides S1 to S4 may be integrally formed.

Sides of the light shielding layer 800 facing each other may have the same width. For example, the first side S1 and the second side S2 facing each other in the second direction DR2 may have the same width. In other words, a width W1 of the first side S1 and a width W2 of the second side S2 may be the same. In addition, the third side S3 and the fourth side S4 facing each other in the first direction DR1 may have the same width. In other words, a width W3 of the third side S3 and a width W4 of the fourth side S4 may be the same. However, the present disclosure is not limited thereto, and the width W3 of the third side S3 and the width W4 of the fourth side S4 may be different.

The light shielding layer 800 may prevent light leakage phenomenon, in which light provided from the display elements 200 is emitted to the edge of the display device. For example, light from display elements 200 that are close to the non-display area NDA of the base substrate 100 among the display elements 200 may be emitted outside through the edge of the display device (e.g., the non-display area NDA of the base substrate 100), and light shielding layer 800 described above can prevent light of the display elements 200 from being emitted to the outside through the edge of the display device. Accordingly, image quality of the display device can be improved. In addition, since the light shielding layer 800 covers the edge of the encapsulation layer 300 that is susceptible to encapsulation, the light shielding layer 800 can prevent air and moisture from permeating into the display elements 200 through the edge of the encapsulation layer 300.

The adhesive layer 400 may be disposed on the light shielding layer 800 and the encapsulation layer 300. For example, the adhesive layer 400 may be disposed on the center of the encapsulation layer 300 in the display area DA of the base substrate 100, and the adhesive layer 400 may be disposed on the edge of the encapsulation layer 300 and the light shielding layer 800 in the non-display area NDA of the base substrate 100.

The adhesive layer 400 may be in contact with the light shielding layer 800 and the encapsulation layer 300. The adhesive layer 400 may adhere the encapsulation layer 300 and the protective substrate 500 to be described later, and adhere the light shielding layer 800 and the protective substrate 500. For example, the adhesive layer 400 may include a pressure sensitive adhesive such as an optically clear resin (OCR) or an optically clear adhesive (OCA).

The protective substrate 500 may be disposed on the adhesive layer 400. The protective substrate 500 may be a flexible substrate which can be bent, folded or rolled. For example, the protective substrate 500 may include a polymer resin such as polyimide (PI), but is not limited thereto. For another example, the protective substrate 500 may include a glass material or a metal material. Here, the glass may be a flexible or rigid glass, and the metal may be a flexible or rigid metal.

The protective substrate 500 may overlap the base substrate 100. For example, the entire protective substrate 500 may be overlapped by the base substrate 100. Meanwhile, the protective substrate 500 described above may have a smaller area than the base substrate 100. For example, the area of the protective substrate 500 along a first direction DR1 and a second direction DR2 may be smaller than the area of the base substrate 100 along the first direction DR1 and the second direction DR2. At this time, in plan view, the edge of the protective substrate 500 may be surrounded by the edge of the base substrate 100. In other words, the edge of the base substrate 100 may extend further in the first direction DR1 and the second direction DR2 than the edge of the protective substrate 500. Like described above, since the area of the protective substrate 500 is smaller than the area of the base substrate 100, dead space of the display device may be minimized. Meanwhile, the length of the protective substrate 500 in the first direction DR1 may be greater than the length of the base substrate 100 in the first direction DR1 as illustrated in FIG. 2, and the length of the protective substrate 500 in the second direction DR1 may be smaller than the length of the base substrate 100 in the second direction DR2 as illustrated in FIG. 1.

The polarization plate 600 may be disposed on the protective substrate 500. For example, the polarization plate 600 may be disposed on the protective substrate 500 in the third direction DR3. The polarization plate 600 may include a linear polarization layer and at least one retardation layer. The linear polarization layer may be an optical layer that linearly polarizes light provided from the outside in one direction. The retardation layer may be a λ/2 retardation layer and a λ/4 retardation layer. The polarization plate 600 may function to reduce reflection caused by external light.

The polarization plate 600 may overlap the base substrate 100. For example, the entire polarization plate 600 may be overlapped by the base substrate 100. Meanwhile, the base substrate 100 described above may have a greater area than the polarization plate 600. For example, the area of the base substrate 100 along the first direction DR1 and the second direction DR2 may be greater than the area of the polarization plate 600 along the first direction DR1 and the second direction DR2. At this time, in plan view, the edge of the base substrate 100 may surround the edge of the polarization plate 600. In other words, the edge of the base substrate 100 may extend further in the first direction DR1 and the second direction DR2 than the edge of the polarization plate 600.

In addition, the polarization plate 600 may overlap the protective substrate 500. For example, the entire polarization plate 600 may overlap the protective substrate 500. Meanwhile, the protective substrate 500 described above may have an area greater than the polarization plate 600. For example, the area of the protective substrate 500 along the first direction DR1 and the second direction DR2 may be larger than the area of the polarization plate 600 along the first direction DR1 and the second direction DR2. At this time, from a plan view, the edge of the polarization plate 600 may surround the edge of the protective substrate 500. In other words, the edge of the protective substrate 500 may extend further in the first direction DR1 and the second direction DR2 than the edge of the polarization plate 600.

Meanwhile, although not illustrated, a color filter may be further disposed between the protective substrate 500 and the polarization plate 600.

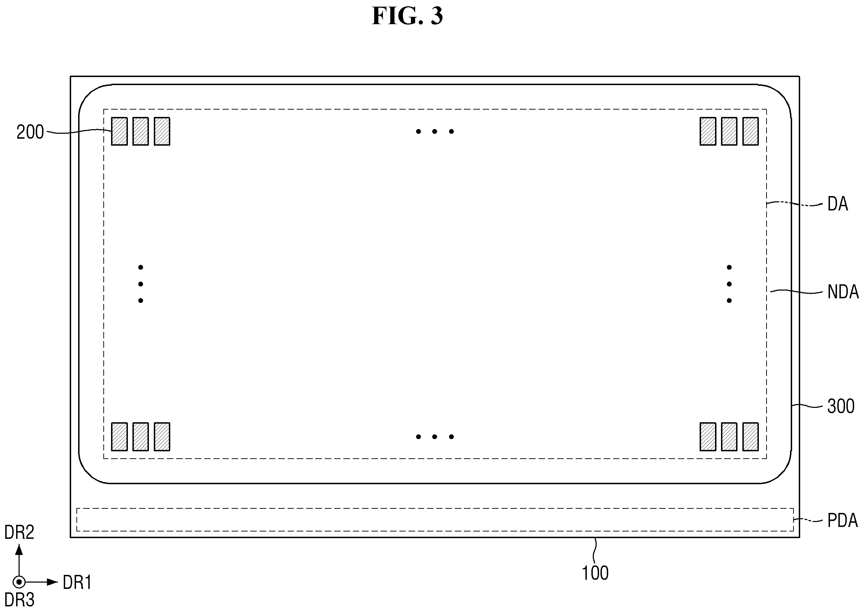

Hereinafter, a method of manufacturing a display device according to an embodiment will be described with reference to FIG. 2 described above and FIGS. 3 to 6 as follows.

FIGS. 3 to 6 are schematic drawings for describing a method of manufacturing a display device according to an embodiment.

First, as illustrated in FIGS. 3 and 2, display elements 200 may be disposed on a display area DA of a base substrate 100, and an encapsulation layer 300 may be disposed on the display area DA and a non-display area NDA of the base substrate 100 to cover the display elements 200.

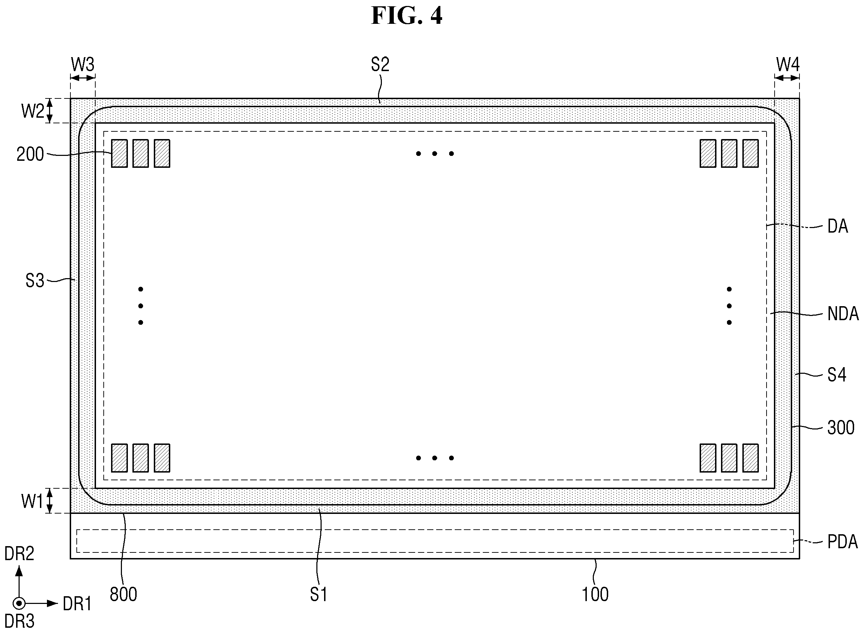

Subsequently, as illustrated in FIGS. 4 and 2, a light shielding layer 800 may be disposed to cover the edge of the encapsulation layer 300 in the non-display area NDA of the base substrate 100. For example, the light shielding layer 800 may be formed by jetting a material (e.g., organic pigment) used in the light shielding layer 800 by using an inkjet equipment. For example, organic pigment sprayed from a nozzle of the inkjet equipment may be formed along the edge of the upper surface of the base substrate 100 and the edge of the upper surface of the encapsulation layer 300. In an embodiment, the light shielding layer 800 may be formed, for example, by applying a material (e.g., organic pigment) used in the light shielding layer 800 by using the inkjet equipment. For example, the organic pigment discharged from a head of the inkjet equipment may be formed along the edge of the upper surface of the base substrate 100 and the edge of the upper surface of the encapsulation layer 300. In an embodiment, the light shielding layer 800 may be formed, for example, by applying the organic pigment using an EHD (electrohydrodynamic) printing equipment. For example, organic pigment discharged from a nozzle of the EHD (electrohydrodynamic) printing equipment may be formed along the edge of the base substrate 100 and the edge of the encapsulation layer 300.

Subsequently, the organic pigment formed along the edge of the base substrate 100 and the edge of the encapsulation layer 300 may be cured through a curing process. The curing process may include, for example, at least one of an ultraviolet curing process, a heat curing process, and a room temperature curing process. In other words, the organic pigment can be cured by applying ultraviolet rays or heat to the organic pigment. Alternatively, organic pigments may be naturally cured by being left at room temperature for a certain period of time. The cured organic pigment may function as the light shielding layer 800.

Subsequently, as illustrated in FIG. 2, an adhesive layer 400 may be disposed on the light shielding layer 800 and the encapsulation layer 300.

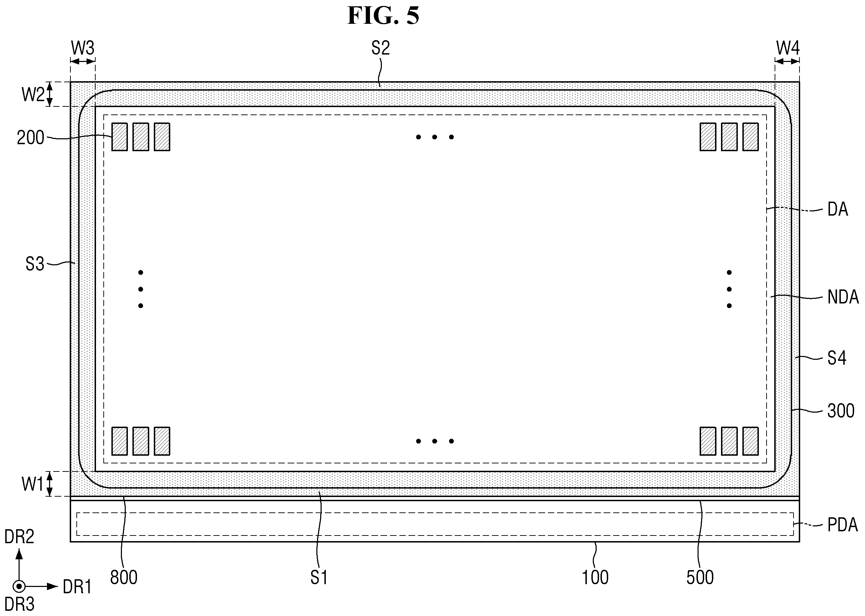

Next, as illustrated in FIGS. 5 and 2, a protective substrate 500 may be disposed on the adhesive layer 400.

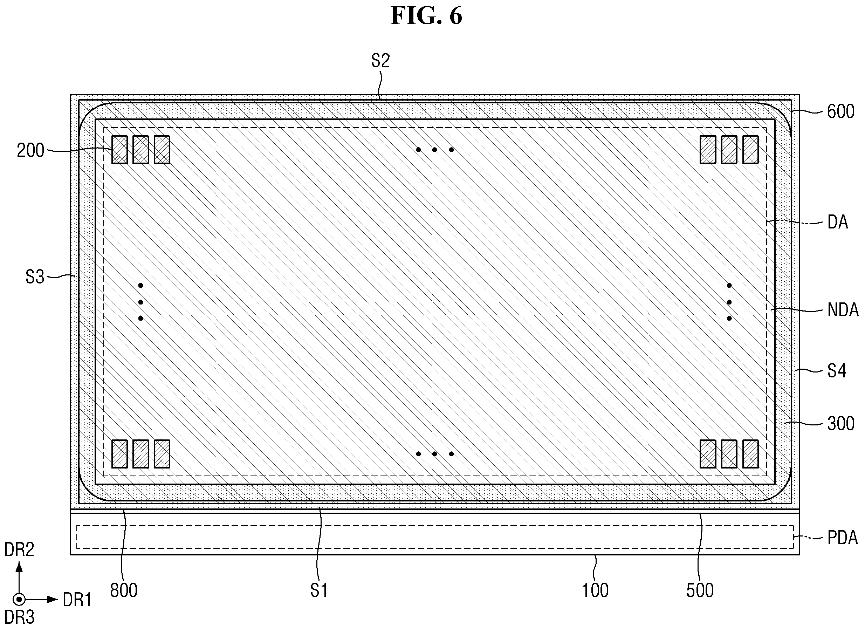

Subsequently, as illustrated in FIGS. 6 and 2, a polarization plate 600 may be disposed on the protective substrate 500.

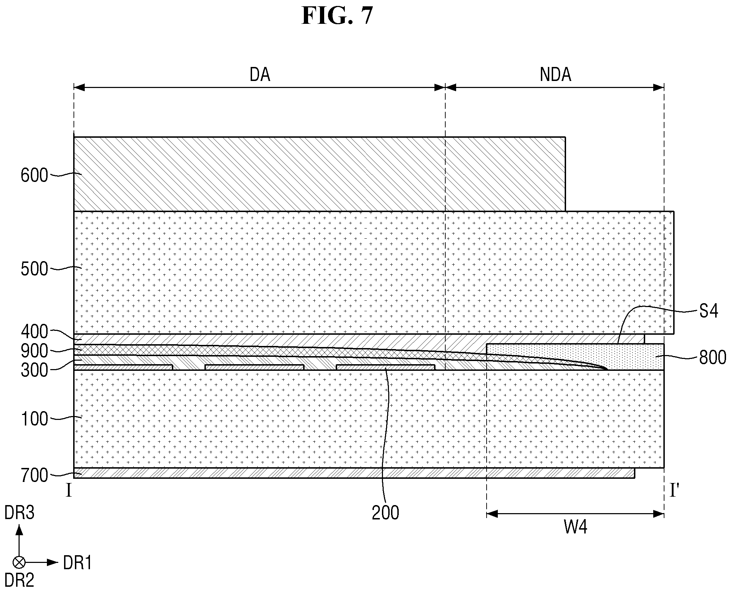

FIG. 7 is schematic cross-sectional view of a display device according to an embodiment, and FIG. 7 may be another cross-sectional view taken along line I-I' of FIG. 1.

The display device of FIG. 7 is different from the display device of FIG. 2 described above in further including a touch sensing unit 900, and the difference will be mainly described as the followings.

As illustrated in FIG. 7, the touch sensing unit 900 may be disposed on the encapsulation layer 300. For example, the touch sensing unit 900 may be disposed between the encapsulation layer 300 and the adhesive layer 400 in the display area DA of the base substrate 100, and may be disposed between the edge of the encapsulation layer 300 and the light shielding layer 800 in the non-display area NDA of the base substrate 100.

The touch sensing unit 900 may be in contact with (or be in direct contact with) the encapsulation layer 300, the light shielding layer 800, and the adhesive layer 400. Here, the interface between the touch sensing unit 900 and the light shielding layer 800 may have a round shape.

The touch sensing unit 900 may include a plurality of touch electrodes for sensing a user's touch in a capacitive manner, and touch lines connecting the plurality of touch electrodes to the touch driver. For example, the touch sensing unit 900 may sense the user's touch by using a mutual capacitance method or a self-capacitance method.

For another example, the touch sensing unit 900 may be disposed on a separate substrate disposed on a display area DA of the display device. In this case, the substrate supporting the touch sensing unit 900 may be a base member that encapsulates the display area DA.

The plurality of touch electrodes of the touch sensing unit 900 may be disposed in a touch sensor area overlapping the display area DA of the display device. The touch lines of the touch sensing unit 900 may be disposed in a touch peripheral area that overlaps a non-display area NDA of the display device.

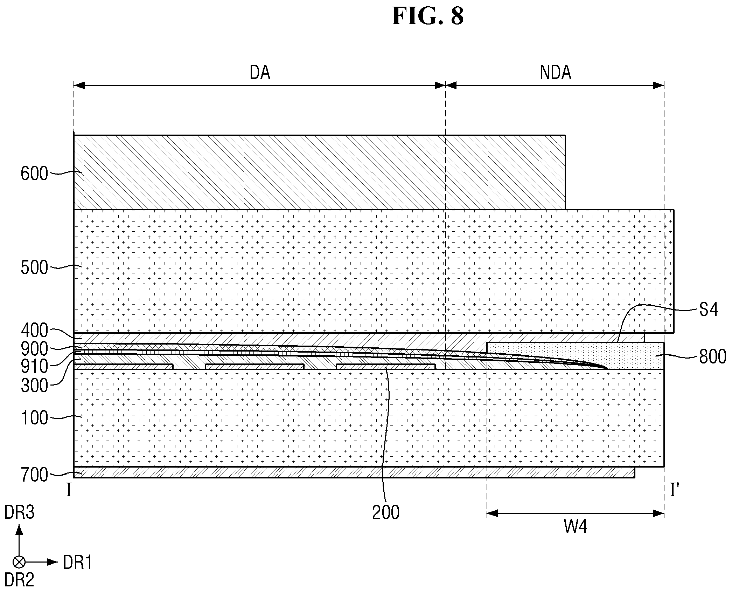

FIG. 8 is a schematic cross-sectional view of a display device according to an embodiment, and FIG. 8 may be another cross-sectional view taken along line I-I' of FIG. 1.

The display device of FIG. 8 is different from the display device of FIG. 7 described above in further including a first planarization layer 910, and the difference will be mainly described as the followings.

As illustrated in FIG. 8, the first planarization layer 910 may be disposed between the encapsulation layer 300 and the touch sensing unit 900.

The first planarization layer 910 is provided in order to allow a touch electrode and touch lines of the touch sensing unit 900 to be disposed on a planarized surface in the display area DA of the base substrate 100, and such first planarization layer 910 may be formed of a material including at least one of an organic layer or an inorganic layer.

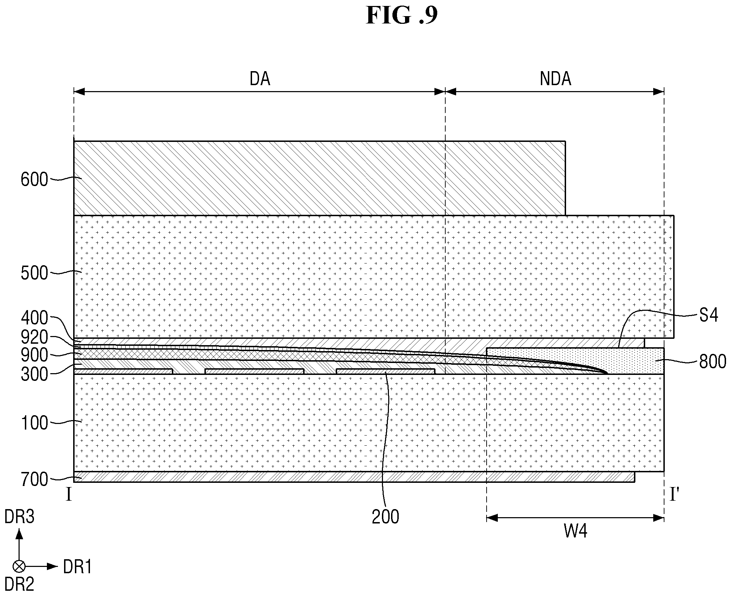

FIG. 9 is schematic a cross-sectional view of a display device according to an another embodiment, and FIG. 9 may be another cross-sectional view taken along line I-I' of FIG. 1.

The display device of FIG. 9 is different from the display device of FIG. 7 described above in further including a second planarization layer 920, and the difference will be mainly described as the followings.

As illustrated in FIG. 9, the second planarization layer 920 may be disposed on the touch sensing unit 900. For example, the second planarization layer 920 may be disposed between the touch sensing unit 900 and the adhesive layer 400 in the display area DA of the base substrate 100, and may be disposed between the edge of the touch sensing unit 900 and the light shielding layer 800 in the non-display area NDA of the base substrate 100.

The second planarization layer 920 may be in contact with (or be in direct contact with) the touch sensing unit 900, the light shielding layer 800, and the adhesive layer 400. Here, the interface between the second planarization layer 920 and the light shielding layer 800 may have a round shape.

The second planarization layer 920 is provided in order to allow the adhesive layer 400 to be disposed on a planarized surface, and such second planarization layer 920 may be formed of a material including at least one of an organic layer or an inorganic layer.

Meanwhile, according to an embodiment, the display device may include both the first and second planarization layers 910 and 920 described above.

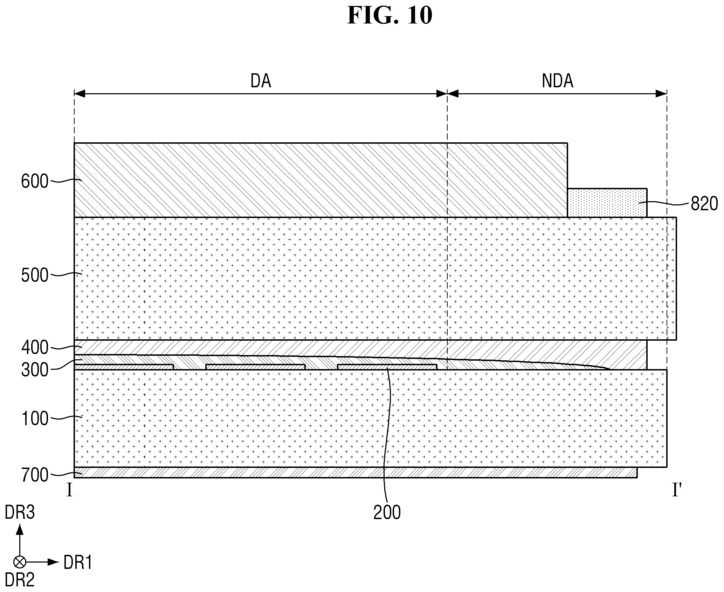

FIG. 10 is a schematic cross-sectional view of a display device according to an embodiment, and FIG. 10 is another cross-sectional view taken along line I-I' of FIG. 1.

The display device of FIG. 10 is different from the display device of FIG. 2 described above in the position of a light shielding layer 820, and the difference will be mainly described as the followings.

As illustrated in FIG. 10, the light shielding layer 820 may be disposed on the protective substrate 500. For example, the light shielding layer 820 may be disposed on the protective substrate 500 in the non-display area NDA. In other words, in the non-display area NDA, the light shielding layer 820 may be disposed directly on the protective substrate 500. According to an embodiment, in the non-display area NDA, the light shielding layer 820 may be disposed on the protective substrate 500 to surround the edge of the encapsulation layer 300.

In plan view, the light shielding layer 820 may have a closed curve shape (e.g., a square ring shape) surrounding a polarization plate 600. The light shielding layer 820 may be in contact with (or be in direct contact with) the upper surface of the protective substrate 500 and the side surface of the polarization plate 600. At this time, the thickness of the light shielding layer 820 may be smaller than the thickness of the polarization plate 600. Here, the thickness of the light shielding layer 820 (or the polarization plate 600) may refer to the magnitude in the third direction DR3.

Meanwhile, according to an embodiment, the light shielding layer 820 may be disposed on the protective substrate 500 to surround the edge of the encapsulation layer 300.

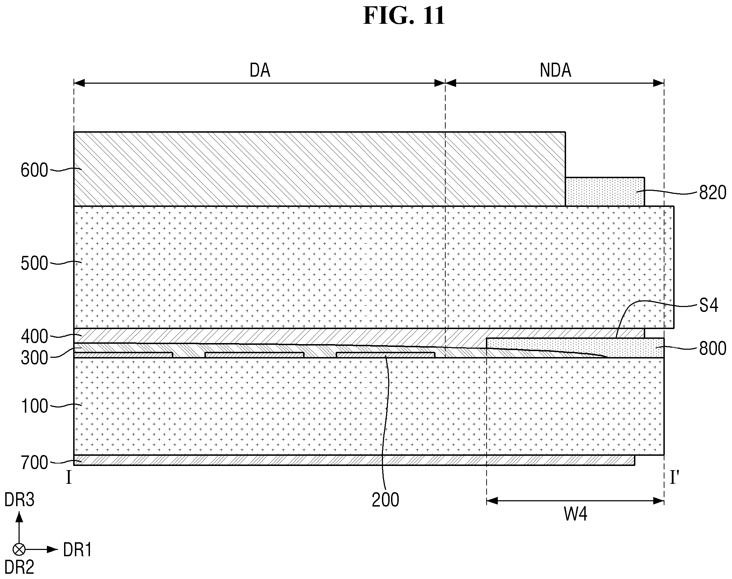

FIG. 11 is a schematic cross-sectional view of a display device according to an embodiment, and FIG. 11 may be a cross-sectional view taken along line I-I' of FIG. 1.

The display device of FIG. 11 is different from the display device of FIG. 10 described above in including two light shielding layers 800, and the difference will be mainly described as the followings.

As illustrated in FIG. 11, one light shielding layer 800 (hereinafter, a first light shielding layer 800) may be disposed on the encapsulation layer 300, and the other light shielding layer 820 (hereinafter, a second light shielding layer 820) may be disposed on the protective substrate 500. In other words, the first light shielding layer 800 may be the same as the light shielding layer 800 of FIGS. 1 and 2 described above, and the second light shielding layer 820 may be the same as the light shielding layer 820 of FIG. 10 described above. Accordingly, detailed description of the first light shielding layer 800 will be referred to the description related to the light shielding layer 800 of FIGS. 1 and 2 described above, and detailed description of the second light shielding layer 820 will be referred to the description related to the light shielding layer 820 of FIG. 10 described above.

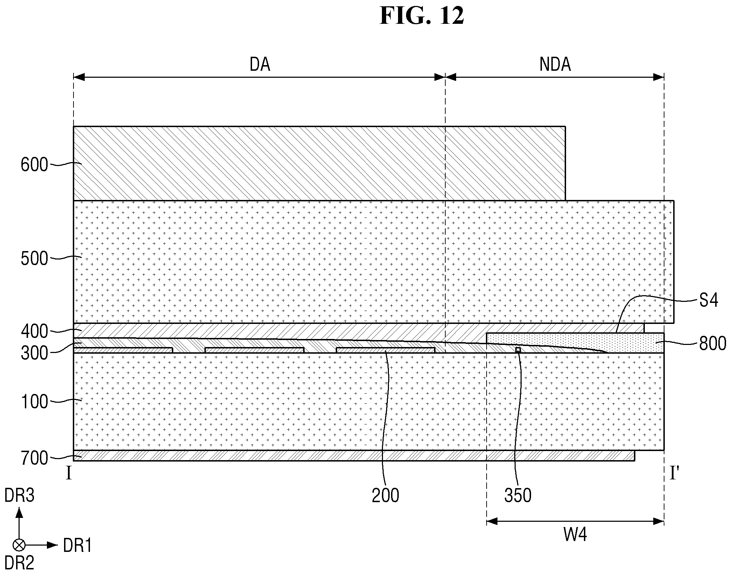

FIG. 12 is a schematic cross-sectional view of a display device according to an embodiment, and FIG. 12 may be another cross-sectional view taken along line I-I' of FIG. 1.

The display device of FIG. 12 is different from the display device of FIG. 2 described above in further including a dam 350, and the difference will be mainly described as the followings.

As illustrated in FIG. 12, at least one dam 350 may be disposed in the non-display area NDA of the base substrate 100. In plan view, the dam 350 may have a closed curve shape surrounding the display area DA.

The encapsulation layer 300 may be disposed on the display elements 200 and the dam 350.

Meanwhile, according to an embodiment, the dam 350 may be disposed in the non-display area NDA to overlap the light shielding layer 800 in the non-display area NDA of the base substrate 100.

In the process of forming the encapsulation layer 300, the dam 350 can prevent a material of the encapsulation layer 300 from permeating into a pad area PDA of the base substrate 100. For example, the encapsulation layer 300 may include a first inorganic layer, an organic layer, and a second inorganic layer stacked along the third direction DR1 on the base substrate 100, and the dam 350 described above can prevent raw material (e.g., a monomer) of an organic layer applied to the base substrate 100 from permeating into the pad area PDA.

Those skilled in the art to which the present specification pertains will understand that the present specification may be embodied in other specific forms without changing the technical spirit or essential characteristics. Therefore, the above-described embodiments are to be understood as illustrative in all respects and not as restrictive. The scope of the present specification is defined by the claims described below rather than by the foregoing detailed description, and all modifications or variations derived from the meaning, scope, and equivalent concepts of the claims should be interpreted as falling within the scope of the present specification.

Meanwhile, the present specification and drawings disclose preferred embodiments of the present specification, and although specific terms have been used, they are used in a general sense merely to facilitate the description of the technical content of the specification and to aid understanding of the invention, and are not intended to limit the scope of the specification. In addition to the embodiments disclosed herein, it will be apparent to those skilled in the art that other modifications based on the technical idea of the present specification may also be implemented.

## Claims

1. A display device comprising:
a base substrate;
a display element disposed on the base substrate in a display area;
an encapsulation layer on the display element; and
a light shielding layer disposed on the encapsulation layer in a non-display area.

2. The display device of claim 1,
wherein the light shielding layer is disposed along the edge of the upper surface of the base substrate and the edge of the upper surface of the encapsulation layer.

3. The display device of claim 1,
wherein, in plan view, the light shielding layer surrounds at least one of the encapsulation layer, the display element, and the display area of the base substrate.

4. The display device of claim 3,
wherein, in plan view, the light shielding layer has a closed curve shape surrounding at least one of the encapsulation layer, the display element, and the display area of the base substrate.

5. The display device of claim 1,
wherein, in a non-display area of the base substrate, the light shielding layer is disposed directly on the encapsulation layer.

6. The display device of claim 5,
wherein, in the non-display area of the base substrate, the light shielding layer is in contact with the encapsulation layer.

7. The display device of claim 6,
wherein an interface between the light shielding layer and the encapsulation layer has a round shape.

8. The display device of claim 1, further comprising an adhesive layer on the encapsulation layer and the light shielding layer.

9. The display device of claim 8, further comprising a touch sensing unit disposed between the encapsulation layer and the adhesive layer, and also disposed between the encapsulation layer and the light shielding layer.

10. The display device of claim 9,
wherein the light shielding layer is in contact with the touch sensing unit.

11. The display device of claim 9, further comprising a first planarization layer between the encapsulation layer and the touch sensing unit.

12. The display device of claim 9, further comprising a second planarization layer disposed between the touch sensing unit and the adhesive layer, and also disposed between the touch sensing unit and the light shielding layer.

13. The display device of claim 8, further comprising a protective substrate on the adhesive layer.

14. The display device of claim 9, further comprising a polarization plate on the protective substrate.

15. The display device of claim 14,
wherein the light shielding layer is disposed on the protective substrate to overlap the edge of the encapsulation layer.

16. The display device of claim 15,
wherein the light shielding layer is disposed directly on the protective substrate.

17. The display device of claim 15,
wherein, in plan view, the light shielding layer surrounds the polarization plate.

18. The display device of claim 15,
wherein the light shielding layer comprises:
a first light shielding layer disposed directly on the encapsulation layer; and
a second light shielding layer disposed directly on the protective substrate to overlap the encapsulation layer.

19. The display device of claim 1, further comprising a dam disposed on the base substrate to overlap the light shielding layer in the non-display area of the base substrate.

20. The display device of claim 19,
wherein a portion of the encapsulation layer is disposed between the dam and the light shielding layer.

21. The display device of claim 1,
wherein the light shielding layer includes a black pigment or an organic black pigment.

22. The display device of claim 1,
wherein the light shielding layer has a square ring shape with four sides.

23. The display device of claim 22,
wherein the four sides comprise:
a first side adjacent to a pad area of the base substrate;
a second side disposed to face the first side;
a third side connected to one end of the first side and one end of the second side; and
a fourth side disposed to face the third side, and connected to the other end of the first side and the other side of the second side.

24. The display device of claim 23,
wherein the width of the first side and the width of the second side are the same, and
the third side and the width of the third side are different.

25. A method for fabricating a display device, the method comprising:
placing a display element on a display area of a base substrate;
placing an encapsulation layer on the display element; and
placing a light shielding layer on the encapsulation layer in a non-display area of the base substrate.

26. The method of claim 25,
wherein the light shielding layer is disposed along the edge of the upper surface of the base substrate and the edge of the upper surface of the encapsulation layer.

27. The method of claim 25,
wherein, in plan view, the light shielding layer surrounds at least one of the encapsulation layer, the display element, and the display area of the base substrate.

28. The method of claim 27,
wherein, in plan view, the light shielding layer has a closed curve shape surrounding at least one of the encapsulation layer, the display element, and the display area of the base substrate.

29. The method of claim 25,
wherein, in the non-display area of the base substrate, the light shielding layer is disposed directly on the encapsulation layer.

30. The method of claim 29,
wherein, in the non-display area of the base substrate, the light shielding layer is in contact with the encapsulation layer.

31. The method of claim 30,
wherein an interface between the light shielding layer and the encapsulation layer has a round shape.
